**Europäisches Patentamt**

**European Patent Office**

**Office européen des brevets**

(19)

(11) Veröffentlichungsnummer: **0 068 579**
**B1**

(12) **EUROPÄISCHE PATENTSCHRIFT**

(45) Veröffentlichungstag der Patentschrift:
**16.10.85**

(51) Int. Cl.⁴: **H 03 D 3/00**

(21) Anmeldenummer: **82200775.3**

(22) Anmeldetag: **23.06.82**

(54) Anordnung zur Demodulation eines frequenzmodulierten Eingangssignals.

(30) Priorität: **25.06.81 DE 3124963**

(43) Veröffentlichungstag der Anmeldung:
**05.01.83 Patentblatt 83/1**

(45) Bekanntmachung des Hinweises auf die Patenterteilung:
**16.10.85 Patentblatt 85/42**

(84) Benannte Vertragsstaaten:
**BE DE FR GB IT**

(56) Entgegenhaltungen:
**EP - A - 0 029 376**
**EP - A - 0 046 213**
**FR - A - 2 219 570**

**R.K. RICHARDS: "Arithmetic operations in digital computers", 1955, D. Van Nostrand Company, Inc., Seiten 166-174, New York, USA**

(73) Patentinhaber: **Philips Patentverwaltung GmbH, Billstrasse 80, D-2000 Hamburg 28 (DE)**
(84) Benannte Vertragsstaaten: **DE**

(73) Patentinhaber: **N.V. Philips' Gloeilampenfabrieken, Groenewoudseweg 1, NL-5621 BA Eindhoven (NL)**
(84) Benannte Vertragsstaaten: **BE FR GB IT**

(72) Erfinder: **Demmer, Walter, Sorthmannweg 15, D-2000 Hamburg 54 (DE)**
Erfinder: **Gutsmann, Rolf-Dieter, Greickstrasse 4A, D-2000 Hamburg 54 (DE)**
Erfinder: **Lenth, Jürgen, Wiebelstrasse 9, D-2000 Hamburg 54 (DE)**

(74) Vertreter: **Poddig, Dieter et al, Philips Patentverwaltung GmbH Billstrasse 80 Postfach 10 51 49, D-2000 Hamburg 28 (DE)**

## Beschreibung

Die Erfindung betrifft eine Anordnung zur Demodulation eines frequenzmodulierten Eingangssignals, das als eine Folge digitaler Abtastwerte vorliegt, mittels eines digitalen Filters, das mindestens zwei in Reihe geschaltete Verzögerungsglieder und einen an den Eingang und den Ausgang dieser Reihenschaltung angeschlossenen Addierer enthält und jeweils drei aufeinanderfolgende Abtastwerte verarbeitet, und einer Dividieranordnung, die jeweils den Quotienten des Ausgangssignals des Filters und des mittleren der drei Abtastwerte erzeugt.

Eine derartige Anordnung wurde in der älteren, nicht vorveröffentlichten EP-A 46 213 vorgeschlagen und löst bereits grundsätzlich das Problem, zeitdiskrete frequenzmodulierte Signale zu demodulieren.

Frequenzmodulierte Signale werden beispielsweise in der Farbfernsehtechnik verwendet, u.a. für die beiden Farbartsignale beim SECAM-Verfahren und bei der magnetischen Bildaufzeichnung, wobei das Leuchtdichte-Signal in ein frequenzmoduliertes Signal umgewandelt und in dieser Form auf einem Magnetband aufgezeichnet wird. Dabei handelt es sich allgemein um sogenannte Breitband-Frequenzmodulation, bei der der maximale Frequenzhub in der Grössenordnung der Mittenfrequenz des frequenzmodulierten Signals liegt.

Aufgabe der Erfindung ist es, eine Anordnung der eingangs genannten Art anzugeben, die trotz Eignung für Breitband-Frequenzmodulation von relativ hohen Frequenzen einfach aufgebaut ist und vollständig als integrierte Schaltung ausgebildet werden kann.

Diese Aufgabe wird erfindungsgemäss dadurch gelöst, dass die Ausgangswerte des Addierers und das Zweifache des jeweils mittleren Abtastwertes mit unterschiedlichem Vorzeichen einem weiteren Addierer zugeführt werden, dessen Ausgang an einen die Dividieranordnung bildenden, aus Subtrahierstufen und Zwischenspeichern nach dem «Pipeline-Prinzip» aufgebauten Dividierer angeschlossen ist. Durch die Verwendung eines etwas komplexeren Filters mit einem Amplitudengang entsprechend einer $\sin^2$-Funktion wird ein breiterer Bereich erhalten, in dem die Amplitude nahezu linear von der Frequenz abhängt, so dass das Ausgangssignal der Dividieranordnung ohne Korrekturfunktion in einem grösseren Bereich direkt das frequenzmodulierte Signal angibt, und die Ausbildung der Dividieranordnung als Dividierer nach dem «Pipeline-Prinzip» ergibt einen einfacheren Aufbau als ein entsprechender Festwertspeicher. Durch das gewählte Aufbauprinzip des Dividierers steht für jede Stufe innerhalb des Dividierers jeweils nahezu ein Abtastintervall als Verarbeitungszeit zur Verfügung, so dass zeitdiskrete Signale mit hoher Abtastfrequenz verarbeitet werden können.

Um auch das digitale Filter für eine hohe Abtastfrequenz besonders gut geeignet zu machen, ist es zweckmässig, dass die Ausgangswerte des Addierers über eine Verzögerungsstufe, die eine Verzögerung um eine Abtastperiode bewirkt, mit dem einen Eingang des weiteren Addierers gekoppelt ist und dass der Ausgang der Reihenschaltung der zwei Verzögerungsglieder um eine Stelle verschoben mit dem anderen Eingang des weiteren Addierers gekoppelt ist. Damit ist auch dieses Filter nach dem «Pipeline-Prinzip» aufgebaut, so dass für jeden Addierer als Verarbeitungszeit nahezu die volle Abtastperiode zur Verfügung steht.

Der Dividierer nach dem «Pipeline-Prinzip» ist nach einer Ausgestaltung der Erfindung dadurch gekennzeichnet, dass der Dividierer Zellen mit je zwei Eingängen und drei Ausgängen aufweist, von denen jede enthält:

eine Subtrahierstufe, die den am ersten Eingang zugeführten Wert von dem am zweiten Eingang zugeführten Wert subtrahiert und die Differenz beider Werte an einem Differenzausgang und das Vorzeichen an einem mit dem dritten Ausgang verbundenen Vorzeichenausgang abgibt,
einen Umschalter, der bei einem positiven Vorzeichen am Vorzeichenausgang der Subtrahierstufe deren Differenzausgang und bei negativem Vorzeichen den zweiten Eingang mit seinem Ausgang verbindet, einen ersten, mit dem Ausgang des Umschalters verbundenen Zwischenspeicher, der über einen Multiplizierer mit dem zweiten Ausgang verbunden ist,
einen zweiten, mit dem ersten Eingang und dem ersten Ausgang verbundenen Zwischenspeicher, wobei beide Zwischenspeicher vom Taktgeber gesteuert werden,
dass der erste Eingang der ersten Zelle mit dem Ausgang der Verzögerungsanordnung und der zweite Eingang der ersten Zelle mit dem Ausgang des Filters gekoppelt und der erste bzw. der zweite Ausgang jeder Zelle mit dem ersten bzw. dem zweiten Eingang jeder folgenden Zelle und der dritte Ausgang jeder Zelle mit je einem vom Taktgeber gesteuerten Schieberegister verbunden ist, dessen Stufenzahl der Anzahl Zellen entspricht, die der zu diesem Schieberegister gehörigen Zelle noch folgen, wobei die Serienausgänge aller Schieberegister parallel die die Momentanfrequenz des Eingangssignals angebenden Digitalwörter abgeben. Ein derartiger Dividierer arbeitet nach dem «Pipeline-Prinzip», wobei die Information also schrittweise durchgeschoben wird und somit mit einer konstanten Verzögerung am Ausgang erscheint. Jedem Bit des am Ausgang des Dividierers erscheinenden Digitalwortes ist eine Zelle zugeordnet, und diese Bits werden durch die nachgeschalteten Schieberegister so verzögert, dass die Bits des Digitalwortes parallel erscheinen. Da die dadurch entstehende zeitliche Verschiebung für alle Digitalwörter konstant ist, wirkt sie sich im demodulierten Signal nicht aus.

Ein derart aufgebauter Dividierer verarbeitet nur vorzeichenlose Zahlen. Es ist daher zweckmässig, dass die erste Zelle des Dividierers mit dem Ausgang des Filters und dem Ausgang der

3 0 068 579 4

Verzögerungseinrichtung über je einen Betragsbildner verbunden ist. Dadurch wird der Aufbau der einzelnen Zellen vereinfacht.

Da ein Dividierer bei sehr kleinen Werten des Nenners überlaufen kann, d.h. der Quotient überschreitet den Wertebereich des Dividierers und die ausgegebenen Bits des Quotienten enthalten alle den logischen Wert «1», oder bei einem gleichzeitig kleinen Wert des Dividenden ein sehr ungenaues Ergebnis entsteht, da die im Dividenden und Divisor enthaltene Quantisierfehler sich sehr stark auswirken, muss der vom Dividierer in solchen Fällen erzeugte Quotient korrigiert werden. Eine weitere Ausgestaltung der Erfindung ist daher dadurch gekennzeichnet, dass dem Ausgang des Dividierers eine Korrekturschaltung nachgeschaltet ist, die eine vom Dividierer als Quotient gelieferte Dualzahl durch den Mittelwert aus der zeitlich unmittelbar vorhergehenden und der zeitlich unmittelbar nachfolgenden Dualzahl ersetzt, wenn der zu der momentan gelieferten Dualzahl gehörige Divisor einen vorgegebenen Wert unterschreitet. Da ein solcher Fall bei einem periodischen Eingangssignal normalerweise nur bei jeweils einem innerhalb mehrerer aufeinanderfolgender Eingangssignalwerte auftritt, und andererseits die Frequenz des Eingangssignals sich zwischen zwei Abtastwerten nicht wesentlich verändert, wird durch diese Verwendung des Mittelwertes anstelle des korrekten Quotienten, kein grosser Fehler erzeugt.

Eine derartige Korrekturschaltung ist vorzugsweise dadurch gekennzeichnet, dass die Korrekturschaltung enthält:

eine Verzögerungsschaltung aus zwei in Reihe geschalteten Registerstufen, die die am Quotienteneingang zugeführten Dualwörter um zwei Taktperioden des Taktgebers verzögert,
einen an den Eingang und den Ausgang der Verzögerungsschaltung angeschlossenen Addierer,
einen mit dem Nennereingang der Korrekturschaltung verbundenen Vergleicher, der die am Nennereingang zugeführte Dualzahl mit einer einstellbaren Schwellwert-Dualzahl vergleicht und ein Signal mit dem einen logischen Wert erzeugt, wenn die zugeführte Dualzahl kleiner ist als die Schwellwert-Dualzahl,
einen vom Vergleicher über eine Verzögerungsstufe mit einer Verzögerungszeit von einer Taktperiode des Taktgebers gesteuerten Umschalter, der beim einen logischen Wert des Ausgangssignals des Vergleichers den Ausgang des Addierers und beim anderen logischen Wert die Verbindung der zwei Registerstufen der Verzögerungsschaltung mit dem Ausgang der Korrekturschaltung verbindet.

Auf diese Weise kann der Quotient bei zu kleinen Werten des Divisors leicht durch den Mittelwert der benachbarten Quotienten ersetzt werden.

Ausführungsbeispiele der Erfindung werden nachstehend anhand der Zeichnung näher erläutert. Es zeigen

Fig. 1 ein Blockschaltbild einer erfindungsgemässen Anordnung zur Demodulation,
Fig. 2 ein detailliertes Blockschaltbild einer derartigen Anordnung mit einem besonders einfachen und schnellen Dividierer,
Fig. 3 das Blockschaltbild einer Korrekturschaltung.

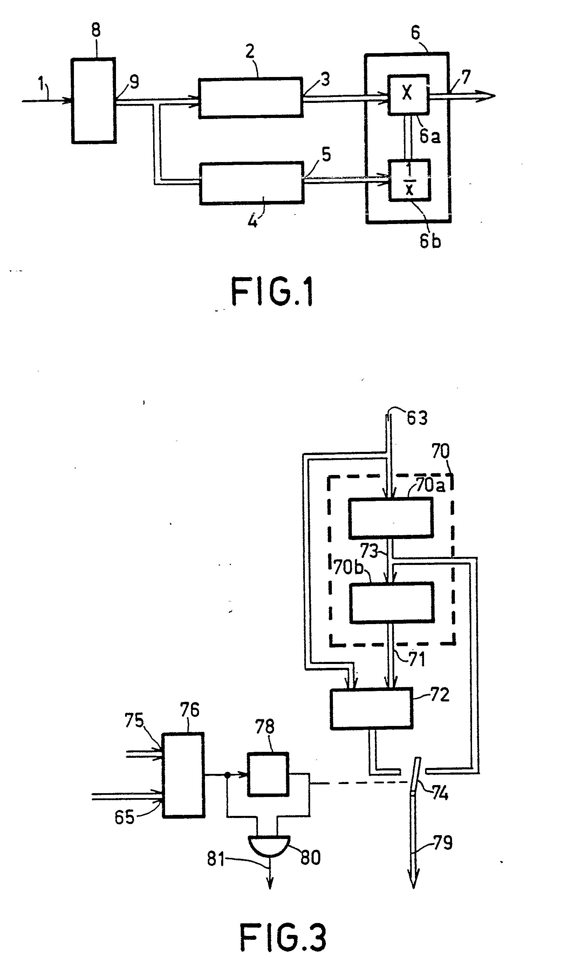

Das in Fig. 1 dargestellte Blockschaltbild zeigt eine Abtasteinrichtung 8, die über den Eingang 1 ein frequenzmoduliertes Signal erhält und die vorzugsweise als Analog-Digital-Wandler ausgebildet ist. Diese Abtasteinrichtung 8 tastet das am Eingang 1 zugeführte analoge Signal zu gleichmässig verteilten Zeitpunkten ab, die durch einen nicht dargestellten Taktgeber bestimmt werden. Am Eingang 9 wird jeder Abtastwert in Form eines mehrstelligen Dualwortes abgegeben, dessen einzelne Bits parallel abgenommen werden, wie die als doppelte Linie dargestellte Verbindung andeutet, die also tatsächlich aus einer Mehrzahl von einzelnen Leitungen besteht.

Die am Ausgang 9 erzeugten Dualwörter werden gleichzeitig einem Filter 2 und einer Verzögerungseinrichtung 4 zugeführt. Das Filter 2 ist ein digitales Transversalfilter mit einer Übertragungskennlinie $A(\omega)$, die zumindest im Bereich der möglichen Frequenzen des über den Eingang 1 zugeführten frequenzmodulierten Signals eine möglichst lineare Kennlinie sowie eine konstante Gruppenlaufzeit aufweist. Am Ausgang 3 des Filters 2 wird daher eine Folge von Dualwörtern erzeugt, die in der gleichen Folge wie die Dualwörter am Ausgang 9 auftreten und die Abtastwerte eines entsprechend gefilterten analogen Signals darstellen. In der Verzögerungseinrichtung 4 werden die am Ausgang 9 auftretenden Dualwörter um eine Zeitdauer verzögert, die gleich der Gruppenlaufzeit des Filters 2 ist, so dass am Ausgang 5 Dualwörter auftreten, die den gleichzeitig am Ausgang 3 des Filters 2 auftretenden Dualwörtern entsprechen, jedoch Abtastwerte des ungefilterten Eingangssignals darstellen.

Die an den Ausgängen 3 und 5 auftretenden Dualwörter werden nun dem Dividierer 6 zugeführt, in dem jedes am Ausgang 3 auftretende Dualwort durch das gleichzeitig am Ausgang 5 auftretende Dualwort dividiert wird, und der Quotient erscheint jeweils am Ausgang 7. Der Zusammenhang zwischen dem durch die Folge der am Ausgang 7 abgegebenen Dualwörter gebildeten Signal $U_a$ und dem am Eingang 1 zugeführten Eingangssignal $U(t)\sin\omega t$ ist dann folgender:

$$U_a = \frac{U(t)\cdot\sin\omega t\cdot e^{-j\omega\tau}\cdot A(\omega)}{U(t)\cdot\sin\omega t\cdot e^{-j\omega\tau}} = A(\omega),$$

wobei $\tau$ die Gruppenlaufzeit des Filters 2 ist.

Dieses Ausgangssignal $U_a$ gibt also die Momentanfrequenz des Eingangssignals an und ist völlig unabhängig von der Amplitude dieses Eingangssignals. Gilt für die Amplitudenübertragungsfunktion

$$A(\omega) = K1 + K2\cdot\omega,$$

3

so ist das Ausgangssignal $U_a$ exakt proportional der Frequenz des Eingangssignals. Eine derartige Übertragungsfunktion lässt sich jedoch mit geringem Aufwand nicht exakt herstellen. Eine gute Annäherung dieser idealen Übertragungsfunktion wird jedoch für viele Anwendungen durch eine $\sin^2$-Übertragungsfunktion gebildet, die wesentlich einfacher erzeugt werden kann, wie später erläutert wird. Es sind ausserdem jedoch noch andere Übertragungsfunktionen für das Filter möglich, mit denen z.B. eine Frequenzgangkorrektur gleichzeitig durchgeführt werden kann.

Es ist zu berücksichtigen, dass bei einem Divisor mit dem Wert Null im Dividierer ein Überlauf entsteht, der zu einem falschen Ergebnis führt. Daher muss in dem Dividierer 6 noch eine Einrichtung vorhanden sein, die prüft, ob der Wert des Divisors gleich Null ist. In diesem Falle wird nicht das Divisionsergebnis verwendet, sondern beispielsweise der Mittelwert aus dem vorhergehenden und dem folgenden Divisionsergebnis. Auch wenn sowohl der Dividend wie auch der Divisor, d.h. die beiden an den Ausgängen 3 und 5 auftretenden Dualwörter, gleichzeitig sehr kleine Werte haben, auch wenn sie noch nicht Null sind, müssen entsprechende Massnahmen ergriffen werden.

Der Dividierer 6 enthält in Fig. 1 einen Kehrwertbildner 6b, der aus einem Festwertspeicher besteht, der an jeder Speicheradresse ein Dualwort enthält, das dem Kehrwert der Adresse entspricht. Dieser Kehrwert wird einem Multiplizierer 6a zugeführt, der ausserdem direkt die vom Ausgang 3 abgegebenen Dualwörter erhält. Am Ausgang 7 entstehen dann Dualwörter mit einem Wert gleich dem Quotienten der beiden gleichzeitig an den Ausgängen 3 und 5 auftretenden Dualwörter.

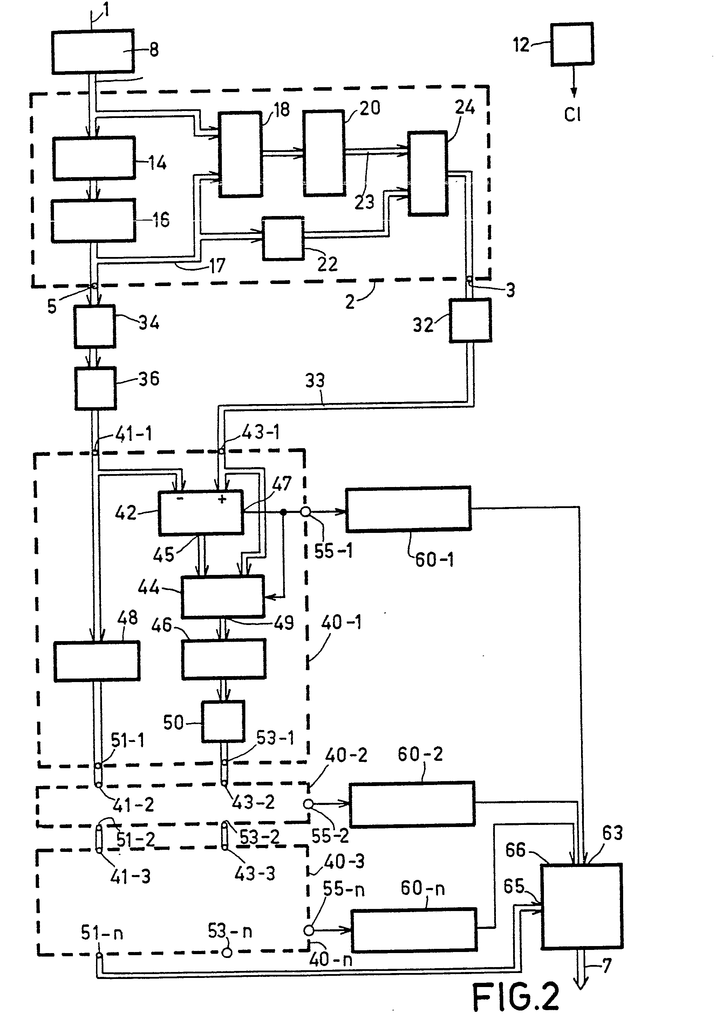

In Fig. 2 sind die in Fig. 1 dargestellten Blöcke detaillierter gezeigt. Die am Ausgang 9 der Abtasteinrichtung 8 erzeugten digitalen Abtastwerte des am Eingang 1 zugeführten analogen Signals werden einer Reihenschaltung von zwei Registerstufen 14 und 16 zugeführt, die mit jedem Takt C1 des Taktgebers 12 das am Eingang anliegende Dualwort übernehmen. Dies gilt auch für die weiteren Registerstufen in Fig. 2 sowie für die Elemente 60-1 bis 60-n, so dass die Taktleitung hier der Übersichtlichkeit halber nicht dargestellt ist. Die beiden Registerstufen 14 und 16 bilden somit eine Verzögerungseinrichtung mit einer Verzögerungszeit von zwei Taktperioden des Taktgebers 12. Die verzögerten Dualwörter werden am Ausgang 5 abgegeben.

Die am Ausgang 9 sowie am Ausgang 5 bzw. auf der Leitung 17 auftretenden Dualwörter werden den beiden Eingängen einer Addierstufe 18 zugeführt, deren Ausgang mit einer Registerstufe 20 verbunden ist. Die Ausgangsleitung 23 dieser Registerstufe, die eine Verzögerung um eine Taktperiode bewirkt, ist mit dem einen Eingang einer weiteren Addierstufe 24 verbunden, deren anderer Eingang über einen Multiplizierer 22 mit dem Faktor 2, der am einfachsten durch eine Stellenverschiebung der zugeführten Dualzahl um ein Bit realisiert wird, mit der Leitung 17 verbunden ist. Der Ausgang der Addierstufe 24 ist mit dem Ausgang 3 des Filters 2 verbunden, das hier durch doppelte Ausnutzung der Registerstufen 14 und 16 die Verzögerungseinrichtung 4 in Fig. 1 mit enthält. Zwischen den Signalen am Ausgang 9 und am Ausgang 3 besteht nun ein Zusammenhang gemäss folgender Übertragungsfunktion:

$$H(Z) = (1 - Z^{-1})^2$$

mit dem Amplitudengang

$$A(\omega) = 4 \cdot \sin^2 \left( \frac{2\omega}{\omega_T} \cdot \pi \right),$$

wobei $\omega_T = 2\pi \cdot f_T$ und $f_T$ die Frequenz des Taktes C1 des Taktgebers 12 ist.

Das Filter 2 in Fig. 2 hat also eine Durchlasskurve, die ein Maximum bei einem Eingangssignal mit einer Frequenz gleich der halben Taktfrequenz aufweist. Bei einem Viertel der Taktfrequenz hat die Kurve einen Wendepunkt und beiderseits dieses Wendepunktes einen annähernd linearen Verlauf.

In einem praktischen Beispiel einer Anwendung in einem Video-Magnetbandgerät hat das aufzuzeichnende Luminanzsignal eine Signalbandbreite von ca. 2,7 MHz. Das damit modulierte und dem Eingang 1 der Anordnung in Fig. 1 bzw. Fig. 2 zugeführte Eingangssignal hat einen Frequenzbereich von 3,3 MHz bis 4,8 MHz, wobei der obere Wert dem Spitzenweiss entspricht. Bei einer Taktfrequenz von 17,73 MHz liegt der Frequenzbereich dieses Eingangssignals in einem weitgehend linearen Bereich der Durchlasskurve des Filters 2.

Da der nachfolgende Dividierer aus den Zellen 40-1 bis 40-n nur vorzeichenlose Zahlen verarbeitet, ist dem Ausgang 3 des Filters 2 ein Betragsbildner 32 und dem Ausgang 5 der Verzögerungsanordnung ein weiterer, vorzugsweise gleich aufgebauter Betragsbildner 34 nachgeschaltet. Diese sind allerdings nur notwendig, wenn davon ausgegangen wird, dass negative Zahlen an den Ausgängen 3 bzw. 5 in Zweierkomplementdarstellung auftreten. Bei einer Darstellung, bei der die Zahlen als Absolutwert mit einem zusätzlichen Vorzeichenbit auftreten, braucht in den Betragsbildnern 32 und 34 dann selbstverständlich nur das Vorzeichenbit abgetrennt zu werden.

Um den Wertebereich des Dividierers möglichst optimal auszunutzen, soll einer Eingangsfrequenz von 4,43 MHz gemäss dem vorher erwähnten praktischen Beispiel der halbe Hub des Ausgangssignals des Dividierers entsprechen. Da andererseits bei dieser Frequenz durch den Aufbau des Filters 2 eine Verdopplung der am Ausgang 3 gelieferten Signale gegenüber den vom Ausgang 9 zugeführten Signalen auftritt, wird auch für die am Ausgang 5 der Verzögerungseinrichtung auftretenden Signale eine Verdopplung eingeführt, indem dem Dividierer ein Multiplizierer 36 mit dem Faktor 2 vorgeschaltet wird. Diese Multiplikation um den Faktor 2 kann in gleicher Weise wie bei dem Multiplizierer 22 ganz einfach durch eine Stellenverschiebung um 1 Bit erreicht werden.

Der Dividierer besteht aus der Reihenschaltung einer Anzahl Zellen 40-1 bis 40-n, die untereinander gleich aufgebaut sind, so dass hier nur die erste Zelle 40-1 ausführlicher dargestellt ist. Die dem Eingang 41-1 zugeführten Dualwörter, die von den am Ausgang 5 der Verzögerungseinrichtung erzeugten Dualwörter abgeleitet sind und die den Divisor darstellen, werden dem Eingang eines Speicherregisters 48 und dem Subtrahiereingang eines Subtrahierers 42 zugeführt. Die dem zweiten Eingang 43-1 über die Verbindung 33 zugeführten, vom Ausgang 3 des Filters 2 abgeleiteten Dualwörter werden dem Subtrahendeneingang des Subtrahierers 42 sowie dem einen Eingang eines Umschalters 44 zugeführt. Der andere Eingang des Umschalters 44, der zweckmässig als elektronischer mehrpoliger Umschalter bzw. als Multiplexer aufgebaut ist, ist mit dem Ausgang 45 des Subtrahierers 42 verbunden. Wenn die am zweiten Eingang 43-1 zugeführte Dualzahl grösser als die oder gleich der am ersten Eingang 41-1 zugeführten Dualzahl ist, erzeugt der Subtrahierer 42 am Vorzeichenausgang 47 eine logische «1», die am Ausgang 55-1 herausgeführt wird und die den Umschalter 44 so umschaltet, dass der Ausgang 45 des Subtrahierers 42 mit dem Ausgang 49 des Umschalters verbunden ist. Wenn dagegen die am Ausgang 41-1 zugeführte Dualzahl grösser ist, erzeugt der Subtrahierer 42 am Vorzeichenausgang 47 eine logische «0», die den Umschalter 44 so schaltet, dass sein Ausgang 49 mit dem zweiten Eingang 43-1 verbunden ist.

Der Ausgang 49 des Umschalters 44 ist mit dem Eingang einer Registerstufe 46 verbunden, die parallel mit allen anderen Registerstufen und damit auch mit der Registerstufe 48 getaktet wird, so dass an den Ausgängen 51-1 und 53-1 zeitlich zusammengehörige Dualwörter gleichzeitig erscheinen, wobei dem Speicherregister 46 lediglich ein Multiplizierer 50 mit dem Faktor 2 nachgeschaltet ist, der wieder durch eine Stellenverschiebung um 1 Bit realisiert ist. Die an den Ausgängen 51-1 und 53-1 der Zelle 40-1 auftretenden Dualwörter werden nun den Eingängen 41-2 und 43-2 der folgenden Zelle 40-2 zugeführt und in gleicher Weise verarbeitet. Die von dem in dieser Zelle 40-2 vorhandenen Subtrahierer, der nicht dargestellt ist, abgegebenen Vorzeichensignale werden wieder über den Ausgang 55-2 herausgeführt. Die am Ausgang 51-2 und 53-2 auftretenden Dualwörter, die ausser der arithmetischen Verarbeitung in dem einen Zweig um eine weitere Taktphase verzögert sind, werden den Eingängen 41-3 und 43-3 der folgenden Zelle 40-3 zugeführt, usw. An den Ausgängen 55-1 bis 55-n treten nun die einzelnen Bits des im Dividierer gebildeten Quotienten auf, und zwar am Ausgang 55-1 das Bit höchster Wertigkeit und an den entsprechenden Ausgängen der folgenden Zellen die Bits absteigender Wertigkeit, jedoch von Zelle zu Zelle um jeweils eine Taktphase des Taktgebers 12 verzögert. Daher sind die Ausgänge 55-1 bis 55-n mit dem Serieneingang je eines Schieberegisters 60-1 bis 60-n verbunden. Dabei weist das Schieberegister 60-1 eine Anzahl von n Stufen auf, das Schieberegister 60-2 hat n-1 Stufen, usw. bis zum Schieberegister 60-n, das nur noch eine einzige Stufe hat. Alle Schieberegister erhalten den Takt C1 des Taktgebers 12 als Schiebetakt. Auf diese Weise treten an den Ausgängen der Schieberegister die einzelnen Bits jeweils eines Quotienten parallel auf.

Der zweite Ausgang 53-n der letzten Zelle 40-n ist nicht angeschlossen, während der erste Ausgang 51-n der letzten Zelle, der eine Dualzahl entsprechend dem zu dem gleichzeitig an den Ausgängen der Schieberegister 60-1 bis 60-n auftretenden Quotienten gehörenden Divisor liefert, ist mit einem Eingang 65 einer Korrekturschaltung 66 verbunden, die ferner einen Quotienteneingang 63 aufweist, der die von den Schieberegistern 60-1 bis 60-n gelieferten Serienausgangssignale als Bits eines Dualwortes parallel erhält. Diese Korrekturschaltung 66 ersetzt die von den Schieberegistern 60-1 bis 60-n gelieferte Dualzahl durch den Mittelwert aus der zeitlich unmittelbar vorhergehenden und zeitlich unmittelbar folgenden Dualzahl, wenn die am Ausgang 51-n auftretende Dualzahl einen vorbestimmten Wert unterschreitet.

Ein Beispiel für eine derartige Korrekturschaltung ist in Fig. 3 dargestellt. Die dem Quotienteneingang 63 zugeführte Dualzahl wird dem einen Eingang eines Addierers 72 sowie einer Verzögerungsschaltung 70 zugeführt, die zwei in Reihe geschaltete Registerstufen 70a und 70b enthält, die parallel von dem Takt C1 des Taktgebers 12 in Fig. 2 angesteuert werden. Der Ausgang 71 der Verzögerungsschaltung 70 ist mit dem anderen Eingang des Addierers 72 verbunden. Die Verbindung 73 der beiden Registerstufen 70a und 70b ist mit dem einen Eingang eines Umschalters 74 verbunden, dessen anderer Eingang von dem Ausgang des Addierers 72 kommt. Der Umschalter 74 ist zweckmässig als elektronischer Umschalter, d.h. als Multiplexer mit einer der Stellenzahl der verarbeitenden Dualzahlen entsprechenden Anzahl von Eingängen und Ausgängen, ausgeführt.

Der Eingang 65 der Korrekturschaltung 66 für den Divisor ist mit dem einen Eingang eines Vergleichers 76 verbunden, dessen anderer Eingang eine einstellbare Schwellwert-Dualzahl erhält. Wenn die am Eingang 65 zugeführte Dualzahl kleiner ist als die Schwellwert-Dualzahl, d.h. der Divisor, der zu dem gleichzeitig am Eingang 63 anliegenden Quotienten gehört, liegt unterhalb der durch die Schwellwert-Dualzahl vorgegebenen Schwelle, erzeugt der Vergleicher 76 ein Ausgangssignal mit beispielsweise dem logischen Wert «1». Der Ausgang des Vergleichers 76 führt auf eine Verzögerungsstufe 78, die als Flip-Flop ausgeführt sein kann und ebenfalls das Taktsignal C1 des Taktgebers 12 in Fig. 2 erhält. Wenn also der Vergleicher 76 ein Ausgangssignal «1» abgibt, erscheint dies eine Taktperiode später am Ausgang der Verzögerungsstufe 78. Zu diesem Zeitpunkt ist die Dualzahl am Eingang 63, die zu einem Quotienten mit einem zu kleinen Wert des Divisors gehört, am Ausgang der Registerstufe 70a angelangt. Der Addierer 72 erhält in diesem Augenblick also die diesem Quotienten zeitlich unmittelbar vorhergehende und zeitlich unmittelbar nachfolgende Dualzahl und bildet die Summe daraus und dividiert diese zur Mittelwertbildung durch den Faktor 2, was mittels einer einfachen Bitverschiebung durch entsprechende Verbindung des Ausgangs des Addierers 72 erfolgen kann. Gleichzeitig wird der Umschalter 74 in die linke Stellung umgeschaltet, so dass anstelle des Quotienten mit dem zu kleinen Divisorwert der Mittelwert aus den benachbarten beiden Quotienten am Ausgang 79 erscheint. Dabei wird vorausgesetzt, dass die gleichzeitig am Eingang 65 erscheinende Dualzahl entsprechend dem Divisor grösser als die Schwellwert-Dualzahl am Eingang 75 des Vergleichers 76 ist, so dass dieser als Ausgangssignal eine logische «0» abgibt. Der Fall mehrerer aufeinanderfolgender zu kleiner Divisorwerte wird anschliessend behandelt.

Mit dem nächsten Taktsignal C1 des Taktgebers 12 in Fig. 2 wird der ungenaue Quotient mit dem zu kleinen Divisor-Ausgang 71 der Verzögerungsschaltung 70 weitergeschoben, während der diesem ungenauen Quotient folgende Quotient an der Verbindung 73 der beiden Registerstufen 70a und 70b und somit am rechten Eingang des Umschalters 74 erscheint. Gleichzeitig hat die Verzögerungsstufe 78 das vorhergehende Ausgangssignal «0» des Vergleichers 76 übernommen und gibt dieses am Ausgang ab, so dass der Umschalter 74 wieder in die rechte Lage umgeschaltet wird und damit der dem ungenauen Quotient folgende Quotient am Ausgang 79 erscheint. Dadurch ist also nur der ungenaue Quotient durch den Mittelwert des vorhergehenden und des nachfolgenden Quotienten ersetzt.

Falls mindestens zwei unmittelbar aufeinanderfolgende Divisoren einen zu kleinen Wert haben, ist dies ein Hinweis daraufhin, dass ein kurzzeitiger Signalausfall, ein sogenannter «Dropout», vorliegt. In diesem Falle liegt am Ausgang der Verzögerungsstufe 78 und des Vergleichers 76 gleichzeitig ein Signal «1» vor, so dass das UND-Glied 80, dessen Eingänge mit diesen beiden Ausgängen verbunden sind, am Ausgang 81 eine logische «1» abgibt. Dieses Signal wird einer weiteren Korrekturschaltung zum Ausgleich derartiger Signalausfälle zugeführt, die beispielsweise an solchen Stellen bei der Anwendung in einem Video-Magnetbandgerät die entsprechenden Werte der vorhergehenden Zeile einsetzt.

Da die unterste vorkommende Frequenz des dem Eingang 1 zugeführten Eingangssignals von Null verschieden ist, liegen die am Ausgang 7 abgegebenen Dualzahlen, die die Frequenz dieses Eingangssignals angeben, ebenfalls in einem gegenüber dem Wert Null verschobenen Bereich. Wenn von dem vorher erwähnten Beispiel eines Video-Magnetbandgerätes ausgegangen wird, bei dem die Frequenzen des Eingangssignals in einem Bereich von 3,3 MHz und 4,8 MHz liegen und die Taktfrequenz des Taktgebers 12 einen Wert von 17,73 MHz hat, und angenommen wird, dass die am Ausgang 9 des Abtasters 8 auftretenden Dualzahlen 8 Bit lang sind, treten am Ausgang 7 Dualzahlen auf, die bei einem Eingangssignal von 3,3 MHz dezimal ausgedrückt einen Wert von 79 und bei 4,8 MHz einen Wert von 146 haben. Die Differenz zwischen diesen beiden Werten beträgt 67, so dass die Auflösung des Ausgangssignals am Ausgang 7 besser als 6 Bit ist, jedoch um den Wert 79 dezimal ausgedrückt verschoben. Um das Ausgangssignal der gesamten Demodulationsanordnung auf den Wert Null zu beziehen, was die weitere Signalverarbeitung, insbesondere die anschliessende Rückumwandlung in ein analoges Signal vereinfacht, kann daher dem Ausgang 7 in Fig. 2 ein nicht dargestellter Subtrahierer nachgeschaltet werden, der von jeder am Ausgang 7 auftretenden Dualzahl den entsprechenden minimalen Wert subtrahiert.

**Patentansprüche**

1. Anordnung zur Demodulation eines frequenzmodulierten Eingangssignals, das als eine Folge digitaler Abtastwerte vorliegt, mittels eines digitalen Filters (2), das mindestens zwei in Reihe geschaltete Verzögerungsglieder (14, 16) und einen an den Eingang und den Ausgang dieser Reihenschaltung angeschlossenen Addierer (18) enthält und jeweils drei aufeinanderfolgende Abtastwerte verarbeitet, und einer Dividieranordnung (6), die jeweils den Quotienten des Ausgangssignals des Filters (2) und des mittleren der drei Abtastwerte erzeugt, dadurch gekennzeichnet, dass die Ausgangswerte des Addierers (18) und das Zweifache des jeweils mittleren Abtastwertes mit unterschiedlichem Vorzeichen einem weiteren Addierer (24) zugeführt werden, dessen Ausgang an einen die Dividieranordnung bildenden, aus Subtrahierstufen (42) und Zwischenspeichern (46, 48) nach dem «Pipeline-Prinzip» aufgebauten Dividierer (40-1 bis 40-n) angeschlossen ist.

2. Anordnung nach Anspruch 1, dadurch gekennzeichnet, dass die Ausgangswerte des Addierers (18) über eine Verzögerungsstufe (20), die eine Verzögerung um eine Abtastperiode bewirkt, mit dem einen Eingang des weiteren Addierers (24) gekoppelt ist und dass der Ausgang der Reihenschaltung der zwei Verzögerungsglieder (14, 16) um eine Stelle verschoben mit dem anderen Eingang des weiteren Addierers (24) gekoppelt ist.

3. Anordnung nach Anspruch 1 oder 2, dadurch gekennzeichnet, dass der Dividierer (6) Zellen (40-1 bis 40-n) mit je zwei Eingängen (41, 43) und drei Ausgängen (51, 53, 55) aufweist, von denen jede enthält:

eine Subtrahierstufe (42), die den am ersten Eingang (41) zugeführten Wert von dem am zweiten Eingang (43) zugeführten Wert subtrahiert und die Differenz beider Werte an einem Differenzausgang (45) und das Vorzeichen an einem mit dem dritten Ausgang (55) verbundenen Vorzeichenausgang (47) abgibt,

einen Umschalter (44), der bei einem positiven Vorzeichen am Vorzeichenausgang (47) der Subtrahierstufe (42) deren Differenzausgang (45) und bei negativem Vorzeichen den zweiten Eingang (43) mit seinem Ausgang (49) verbindet,

einen ersten, mit dem Ausgang (49) des Umschalters (44) verbundenen Zwischenspeicher (46), der über einen Multiplizierer (50) mit dem zweiten Ausgang (55) verbunden ist,

einen zweiten, mit dem ersten Eingang (41) und dem ersten Ausgang (51) verbundenen Zwischenspeicher (48), wobei beide Zwischenspeicher vom Taktgeber (12) gesteuert werden,

dass der erste Eingang (41-1) der ersten Zelle (40-1) mit dem Ausgang (5) der Verzögerungsanordnung (14, 16) und der zweite Eingang (43-1) der ersten Zelle (40-1) mit dem Ausgang (3) des Filters (2) gekoppelt und der erste bzw. der zweite Ausgang (51-1, 51-2...; 53-1, 53-2..) jeder Zelle (40-1, 40-2...) mit dem ersten bzw. dem zweiten Eingang (41-2, 41-3...; 43-2, 43-3...) jeder folgenden Zelle (40-2, 40-3...) und der dritte Ausgang (55-1, 55-2...) jeder Zelle (40-1, 40-2...) mit je einem vom Taktgeber (12) gesteuerten Schieberegister (60-1, 60-2...) verbunden ist, dessen Stufenzahl der Anzahl der Zellen entspricht, die der zu diesem Schieberegister gehörigen Zelle noch folgen, wobei die Serienausgänge aller Schieberegister (60-1, 60-2...) parallel die die Momentanfrequenz des Eingangssignals angebenden Digitalwörter abgeben.

4. Anordnung nach Anspruch 3, dadurch gekennzeichnet, dass die erste Zelle (40-1) des Dividierers (6) mit dem Ausgang (3) des Filters (2) und dem Ausgang (5) der Verzögerungseinrichtung (4) über je einen Betragsbildner (32, 34) verbunden ist.

5. Anordnung nach Anspruch 1 oder einem der folgenden, dadurch gekennzeichnet, dass dem Ausgang des Dividierers (6) eine Korrekturschaltung (66) nachgeschaltet ist, die eine vom Dividierer als Quotient gelieferte Dualzahl durch den Mittelwert aus der zeitlich unmittelbar vorhergehenden und der zeitlich unmittelbar nachfolgenden Dualzahl ersetzt, wenn der zu der momentan gelieferten Dualzahl gehörige Divisor einen vorgegebenen Wert unterschreitet.

6. Anordnung nach Anspruch 5, dadurch gekennzeichnet, dass die Korrekturschaltung (66) enthält:

eine Verzögerungsschaltung (70) aus zwei in Reihe geschalteten Registerstufen (70a, 70b), die die am Quotienteneingang (63) zugeführten Dualwörter um zwei Taktperioden des Taktgebers (12) verzögert, einen an den Eingang (63) und den Ausgang (71) der Verzögerungsschaltung (70) angeschlossenen Addierer (72),

einen mit dem Divisoreingang (65) der Korrekturschaltung (66) verbundenen Vergleicher (76), der die am Divisoreingang (65) zugeführte Dualzahl mit einer einstellbaren Schwellwert-Dualzahl vergleicht und ein Signal mit dem einen logischen Wert erzeugt, wenn die zugeführte Dualzahl kleiner ist als die Schwellwert-Dualzahl,

einen vom Vergleicher (76) über eine Verzögerungsstufe (78) mit einer Verzögerungszeit von einer Taktperiode des Taktgebers (12) gesteuerten Umschalter (74), der beim einen logischen Wert des Ausgangssignals des Vergleichers (76) den Ausgang des Addierers (72) und beim anderen logischen Wert die Verbindung (73) der zwei Registerstufen (70a, 70b) der Verzögerungsschaltung mit dem Ausgang der Korrekturschaltung verbindet.

## Claims

1. An arrangement for demodulating a frequency-modulated input signal which is available as a sequence of digital sampling valves, by means of a digital filter (2) comprising at least two series arranged delay devices (14, 16) and an adder (18) connected to the input and to the output of this series arrangement and processing three consecutive sampling values, and a divider arrangement (6) which produces the quotients of the output signal of the filter (2) and the second of the three sampling values, characterized in that the output value of the adder (18) and double the value of each second sampling value with different signs are applied to a further adder (24) whose output is connected to a divider (40-1 to 40-n) which constitutes the divider arrangement and is formed from subtracting stages (42) and intermediate stores (46, 48) in accordance with the «pipeline» principle.

2. An arrangement as claimed in Claim 1, characterized in that the output values of the adder (18) are coupled to one input of the further adder (24) via a delay stage (20) which produces a delay of one sampling value and that the output of the series arrangement of the two delay devices (14, 16) is coupled, shifted through one position, to the other input of the further adder 24.

3. An arrangement as claimed in Claim 1 or 2, characterized in that the divider (6) has sections (40-1 to 40-n) each having two inputs (41, 43) and three outputs (51, 53, 55) each of these sections comprising:

a substracting stage (42) which substracts the value applied to the first input (41) from the value applied to the second input (43) and applies the difference between the two values to a differential output (45) and the sign to a sign output (47) which is connected to the third output (55),

a change-over switch (44), which at a positive sign at the sign output (47) of the substracting stage (42) connects the differential output (45) and at a negative sign the second input (43) to its output (49),

a first intermediate store (46) which is connected to the output (49) of the change-over switch (44) and via a multiplier (50) to the second output (55), a second intermediate store (48) connected to the first input (41) and to the first output (51), the two intermediate stores being controlled by the clock pulse generator (12), that the first input (41-1) of the first section (40-1) is coupled to the output (5) of the delay device (14, 16) and the second input (43-1) of the first section (40-1) to the output (3) of the filter (2) and the first and second output, respectively (51-1, 51-2, ...; 53-1, 53-2, ...) of each section (40-1, 40-2, ...) is connected to the first and to the second input respectively (41-2, 41-3, ...; 43-2, 43-4, ...) of each next section (40-2, 40-3, ...) and the third output (55-1, 55-2, ...) of each section (40-1, 40-2, ...) is connected to a respective shift register (60-1, 60-2, ...), each register being controlled by the clock pulse generator (12), the number of register stages corresponding to the number of sections subsequent to the section associated with this shift register, the series output of all the shift registers (60-1, 60-2, ...) supplying in parallel the digital words which indicate the instantaneous frequency of the input signal.

4. An arrangement as claimed in Claim 3, characterized in that the first section (40-1) of the divider (6) is connected to the output (3) of the filter (2) and to the output (5) of the delay device (4), each via an amount former (32, 34).

5. An arrangement as claimed in Claim 1 or in any of the subsequent claims, characterized in that a correction circuit (66) which replaces the binary number supplied as a quotient by the divider by the mean value of the chronologically immediately preceding and the chronologically immediately following binary number when the divisor associated with the instantaneously supplied binary number falls short of a predetermined value is arranged after the output of the divider (6).

6. An arrangement as claimed in Claim 5, characterized in that the correction circuit (66) comprises:

a delay circuit (70) formed by two series-arranged register stages (70a, 70b), which delays the binary numbers applied to the quotient input by two clock pulse periods of the clock pulse generator (12), one at the input (63) and one at the output (71) of the adder (72) connected to the delay circuit (70),
a comparator (76) which is connected to the divisor input (65) of the correction circuit (66) and which compares the binary number applied to the divisor input (65) with an adjustable threshold value-binary number and produces a signal having one logic value when the applied binary number is smaller than the threshold value-binary number,
a change-over switch (74) which is controlled by a comparator (76) via a delay stage (78) having a time delay of one clock pulse period of the clock pulse generator (12) and which at one logic value of the output signal of the comparator (76) connects to the output of the adder (72) and at the other logic value junction (73) between the two register stages (70a, 70b) of the delay circuit to the output of the correction circuit.

## Revendications

1. Dispositif pour la démodulation d'un signal d'entrée modulé en fréquence, qui se présente comme une série de valeurs d'échantillonnage numériques, à l'aide d'un filtre numérique (2), contenant au moins deux éléments à retard (14, 16), qui sont montés en série et contiennent un dispositif additionneur (18) connecté à l'entrée et à la sortie de ce montage en série et traitant chaque fois trois valeurs d'échantillonnage successives, et un dispositif diviseur (6) permettant de réaliser chaque fois les quotients du signal de sortie du filtre (2) et de la valeur d'échantillonnage centrale des trois valeurs de balayage, caractérisé en ce que les valeurs de sortie du dispositif additionneur (18) et le double de chaque fois la valeur d'échantillonnage centrale de signes différents sont amenés à un autre dispositif additionneur (24), dont la sortie est connectée à un dispositif diviseur (40-1 à 40-n) formé selon le «principe de pipeline» à partir d'étages de soustraction (42) et des mémoires intermédiaires (46, 48) constituant le dispositif diviseur.

2. Montage selon la revendiction 1, caractérisé en ce que la valeur de sortie du dispositif additionneur (18) est couplée à l'entrée d'un autre additionneur (24) par l'intermédiaire d'un étage à retard (20), provoquant un retard d'une période d'échantillonnage et que la sortie du montage en série des deux éléments à retard (14, 16) est couplée, d'une façon décalée sur une position, à l'autre entrée de l'autre dispositif additionneur (24).

3. Dispositif selon la revendication 1 ou 2, caractérisé en ce que le dispositif diviseur (6) présente des cellules (40-1 à 40-n) présentant chaque fois deux entrées (41, 43) et trois sorties (51, 53, 55) dont chacune contient:

un étage de soustraction (42) assurant la soustraction de la valeur amenée à la première entrée (41) de la valeur amenée à la deuxième entrée (43) et délivrant la différence des deux valeurs à une sortie de différence (45) et le signe à une sortie de signe (47) connectée à la troisième sortie (55),
un commutateur (44) assurant la connexion de la sortie de différence (45) de l'étage de soustraction (42) à la sortie (49) dans le cas d'un signe positif se présentant à la sortie de signe (47) et la connexion de la deuxième entrée (43) à ladite sortie (47) dans le cas d'un signe négatif,
une première mémoire intermédiaire (46) connectée à la sortie (49) du commutateur (44) et par l'intermédiaire d'un multiplicateur (50) à la deuxième sortie (55) une deuxième mémoire intermédiaire (48) connectée à la première entrée (41) et à la première sortie (51), les deux mémoires intermédiaires étant commandées par le générateur d'impulsions (12)

que la première entrée (41-1) de la première cellule (40-1) est couplée à la sortie (5) du dispositif à retard (14, 16) et la deuxième entrée (43-1) de la première cellule (40-1) à la sortie (3) du filtre (2) et la première respectivement deuxième sortie (51-1, 51-2...; 53-1, 53-2...) de chaque cellule (40-1, 40-2...) à la première respectivement deuxième entrée (41-2, 41-3...; 43-2, 43-3...) de chaque cellule suivante (40-2, 40-3...) et la troisième sortie (55-1, 55-2...) de chaque cellule (40-1, 40-2...) avec chaque fois un registre à décalage (60-1, 60-2...) du générateur d'impulsions (12), registre à décalage dont le nombre d'étages correspond au nombre de cellules suivant les cellules appartenant à ce registre à décalage, les sorties série de tous les registres à décalage (60-1, 60-2) délivrant parallèlement les mots numériques indiquant la fréquence instantanée du signal d'entrée.

4. Montage selon la revendication 3, caractérisé en ce que la première cellule (40-1) du dispositif diviseur (6) est connectée à la sortie 3 du filtre (2) et à la sortie (5) du dispositif à retard (4) par l'intermédiaire de chaque fois un formateur de valeur (32, 34).

5. Dispositif selon la revendication 1 ou l'une des suivantes, caractérisé en ce qu'après la sortie du dispositif diviseur (6) est monté un circuit de correction (66) remplaçant un chiffre binaire délivré comme quotient par le dispositif diviseur par la valeur moyenne des valeurs précédant immédiatement dans le temps et le membre binaire suivant immédiatement dans le temps lorsque le diviseur appartenant au membre binaire délivré instantanément dépasse une valeur prédéterminée.

6. Dispositif selon la revendication 5, caractérisé en ce que le circuit de correction (66) contient:

un circuit à retard (70) constitué par deux étages d'enregistrement (70a, 70b) montés en série assurant un retard de deux périodes d'impulsion du générateur d'impulsions (12) des mots binaires amenés à l'entrée de quotient (63), un dispositif additionneur (72) connecté à l'entrée (63) et à la sortie (71) du circuit à retard (70), un circuit comparateur (76) connecté à l'entrée de division (65) du circuit de correction (66), assurant la comparaison du nombre binaire amené à l'entrée de division (65) avec un nombre binaire-valeur de seuil réglable et réalise un signal d'une valeur logique lorsque le nombre binaire amené est inférieur au nombre binaire-valeur de seuil, un commutateur (74) commandé par le circuit comparateur (76) par l'intermédiaire d'un étage à retard (78) avec une durée de retard d'une période d'impulsion du générateur d'impulsions (12) assurant la connexion de la sortie du dispositif additionneur (72) à la sortie du circuit de correction dans le cas d'une valeur logique du signal de sortie du circuit comparateur (76) et celle de la connexion (73) des deux étages à registre (70a, 70b) du circuit à retard à la sortie du circuit de correction dans le cas de l'autre valeur logique.

FIG.1

FIG.3

FIG.2